# DEMANDE DE BREVET EUROPEEN

(11) **EP 4 683 467 A1**
(43) Date de publication de la demande: **21.01.2026**
(21) Numéro de dépôt: 25190364.7
(22) Date de dépôt: 18.07.2025
(51) Int. Cl.: H10H 29/01, H10H 29/856

(54) **DISPOSITIF OPTOÉLECTRONIQUE À EXTRACTION LUMINEUSE AMÉLIORÉE**

(30) Priorité: 19.07.2024 FR 2407931
(71) Demandeur: Commissariat à l'Energie Atomique et aux Energies Alternatives, 75015 Paris (FR)
(72) Inventeur: BILDE, Jérémy, 38054 GRENOBLE Cedex 09 (FR); GASSE, Adrien, 38054 GRENOBLE Cedex 09 (FR); NOGUET, Dominique, 38054 GRENOBLE Cedex 09 (FR)
(74) Mandataire: Hautier IP

(57) **Abrégé**

L'invention concerne un procédé de fabrication d'un dispositif optoélectronique (1). Le procédé comprend tout d'abord la fourniture d'un empilement comprenant un substrat (10) dont la face supérieure s'étend selon un plan longitudinal (XY), une première diode (100a) et une deuxième diode (100b) séparées deux à deux par une tranchée (1000). On forme ensuite dans la tranchée (1000) un miroir (500) présentant un premier flanc (500a) et un deuxième flanc (500b) orientés respectivement en regard de la première diode et de la deuxième diode, formant chacun une interface de réflexion pour de la lumière émise ou reçue par les diodes, de sorte que les interfaces de réflexion forment chacune un angle dit de réflexion avec le plan longitudinal (XY), mesuré dans le miroir (500), inférieur à 89°.

## Description

### DOMAINE TECHNIQUE

La présente invention concerne le domaine des technologies de la microélectronique et de l'optoélectronique, notamment la fabrication de réseaux de diodes émettrices ou réceptrices de lumière telles que des LED (de l'anglais « Light-Emitting Diode », se traduisant en français par diode électroluminescente), et tout particulièrement de micro-LED. Elle trouve pour application particulièrement avantageuse mais non limitative les systèmes d'affichage à base de micro-LED, ou les systèmes de communication optique.

### ETAT DE LA TECHNIQUE

Lors de la fabrication d'une diode, et tout particulièrement d'une micro-diode, il est courant de former un miroir sur ses parois latérales. Un tel miroir a deux fonctions principales : éviter le phénomène de diaphonie optique (couramment désigné par le terme anglais de « optical crosstalk ») entre les LEDs lorsqu'elles sont mises en réseau et augmenter l'extraction ou la détection de lumière émise ou reçue par la LED.

Une méthode connue pour fabriquer des matrices de LED à haute densité est de procéder au transfert d'un substrat épitaxié sur un substrat support, puis de singulariser les LED en formant des tranchées dans le substrat épitaxié. Les miroirs bordant les LED sont alors typiquement obtenus en remplissant les tranchées entre les LED avec un matériau approprié.

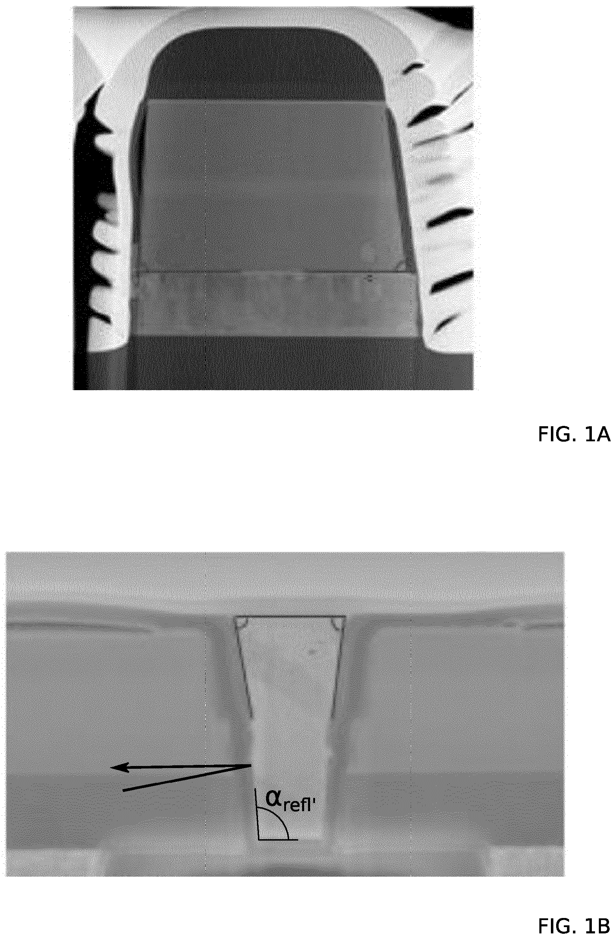

Lors de ce processus, les tranchées sont typiquement réalisées par une gravure plasma anisotrope afin de parvenir à des LED présentant des flancs quasi perpendiculaires au substrat support. Cependant, il a été remarqué dans la pratique qu'après une telle gravure, les flancs des LED ne sont pas perpendiculaires au substrat support, comme espéré, mais présentent une inclinaison donnant aux LED une forme évasée vers le substrat porteur, comme cela est mis en évidence par la vue reproduite à la figure 1A. En déposant par la suite un matériau réflecteur dans les tranchées (figure 1B), le miroir sera incliné en étant orienté en regard du substrat porteur (angle de réflexion α_{refl}') et aura donc pour effet, dans le cas d'une diode émettrice, de rediriger la lumière émise par la LED vers le substrat porteur. Cette situation est préjudiciable pour l'extraction de la lumière par la face supérieure de la LED émettrice. Dans le cas d'une diode réceptrice, cela diminue la zone de réception de la lumière, ce qui est préjudiciable pour le rendement de détection.

De plus, ce procédé de gravure tend à réduire la surface émissive ou la surface de réception de la LED, c'est-à-dire ici la superficie de sa face supérieure, ce qui minimise encore l'intensité lumineuse émise ou la détection de la lumière.

Une autre approche consiste en la formation de miroirs entre les LED, non pas contre leurs parois latérales mais sur un élément situé entre deux LED adjacentes. Une telle méthode est notamment décrite dans le document US 2021328116 A1. Cette approche nécessite cependant un espacement important entre les LED adjacentes et ne permet donc pas la réalisation de matrices de micro-LED présentant une forte densité.

Il existe donc un besoin pour améliorer l'extraction lumineuse ou la réception de lumière au sein d'une matrice de micro-LED. De préférence, cette amélioration serait obtenue sans avoir à concéder une importante réduction de la densité de la matrice ou une augmentation du crosstalk optique.

### RESUME

Pour atteindre cet objectif, un premier aspect de l'invention concerne un procédé de fabrication d'un dispositif optoélectronique comprenant les étapes suivantes :
- fournir un empilement comprenant :
   i. un substrat présentant une face supérieure s'étendant principalement dans un plan dit plan longitudinal,
   ii. une matrice de diodes photoémettrices ou photoréceptrices disposées sur la face supérieure du substrat, au moins une première diode et une deuxième diode de la matrice étant séparées par une tranchée,
- former dans la tranchée un miroir à base d'un premier matériau métallique, la formation du miroir comprenant une étape de dépôt du premier matériau métallique en phase vapeur,

Avantageusement, les dimensions de la tranchée et au moins un paramètre de dépôt du premier matériau métallique en phase vapeur sont configurés pour que le miroir présente :
- un premier flanc orienté en regard de la première diode, formant une interface dite première interface de réflexion pour de la lumière émise ou reçue par la première diode,
- un deuxième flanc orienté en regard de la deuxième diode formant une interface dite deuxième interface de réflexion pour de la lumière émise ou reçue par la deuxième diode,
de sorte que la première interface de réflexion et la deuxième interface de réflexion forment chacune un angle dit de réflexion avec le plan longitudinal, mesuré dans le miroir, inférieur à 89°, de sorte que la première interface de réflexion et la deuxième interface de réflexion s'éloignent respectivement de la première diode et de la deuxième diode dans le plan longitudinal au fur et à mesure qu'elles s'éloignent du substrat.

Dans le cas d'une diode émettrice, les interfaces de réflexion définies par les flancs du miroir permettent de réfléchir la lumière émise par la première diode électroluminescente et la deuxième diode électroluminescente n'étant pas directement extraite par leurs faces supérieures. L'inclinaison des interfaces de réflexion permet de rediriger cette lumière vers les faces supérieures et donc d'en faciliter l'extraction. L'extraction lumineuse de la première diode électroluminescente et de la deuxième diode électroluminescente s'en retrouve largement améliorée.

Dans le cas d'une diode réceptrice, les interfaces de réflexion définies par les flancs du miroir permettent de réfléchir vers les zones actives de la première diode et de la deuxième diode la lumière arrivant à proximité des diodes ou arrivant sur les diodes mais pas vers leurs zones actives respectives. L'inclinaison des interfaces de réflexion permet de rediriger cette lumière vers les zones actives et donc d'en faciliter la détection. La détection lumineuse de la première diode et de la deuxième s'en retrouve largement améliorée.

En outre, la réflexion de la lumière émise ou reçue par la première diode en direction de son flanc permet d'éviter qu'elle n'interfère avec la lumière émise ou reçue par les autres diodes de la matrice et notamment par la deuxième diode (ou inversement). Le phénomène de diaphonie optique entre les diodes de la matrice, ou crosstalk optique, est ainsi limité voire supprimé.

Le paramètre du dépôt peut notamment être pris parmi : la distance entre la cible (source de premier matériau métallique) et l'empilement lors du dépôt, la pression de dépôt, l'utilisation d'un collimation entre la cible et l'empilement lors du dépôt, le dépôt d'ions plutôt que d'espèces neutres.

Un deuxième aspect de l'invention concerne un dispositif optoélectronique comprenant :
- un substrat présentant une face supérieure s'étendant principalement dans un plan dit plan longitudinal,
- une matrice de diodes photoémettrices ou photoréceptrices disposées sur la face supérieure du substrat, au moins une première diode et une deuxième diode de la matrice étant séparées par une tranchée,

Avantageusement, la tranchée comprend un miroir à base d'un premier matériau métallique, le miroir présentant :
- un premier flanc en regard de la première diode, formant une interface dite première interface de réflexion pour de la lumière émise ou reçue par la première diode,
- un deuxième flanc en regard de la deuxième diode formant une interface dite deuxième interface de réflexion pour de la lumière émise ou reçue par la deuxième diode,
de sorte que la première interface de réflexion et la deuxième interface de réflexion forment chacune un angle dit de réflexion avec le plan longitudinal, mesuré dans le miroir, inférieur à 89°, de sorte que la première interface de réflexion et la deuxième interface de réflexion s'éloignent respectivement de la première diode et de la deuxième diode dans le plan longitudinal au fur et à mesure qu'elles s'éloignent du substrat. De préférence, le miroir s'étendant dans tout le volume défini entre son premier flanc et son deuxième flanc.

Les avantages procurés par le procédé selon l'invention s'appliquent mutatis mutandis au dispositif selon l'invention, et inversement.

### BREVE DESCRIPTION DES FIGURES

Les buts, objets, ainsi que les caractéristiques et avantages de l'invention ressortiront mieux de la description détaillée d'un mode de réalisation de cette dernière qui est illustrée par les dessins d'accompagnement suivants dans lesquels :
La figure 1A représente une vue d'une diode obtenue par gravure plasma anisotrope.
La figure 1B représente une vue d'un miroir formé entre deux diodes obtenues par gravure plasma anisotrope.
Les figures 2A à 2N illustrent différents modes de réalisation du procédé selon l'invention.
Les figures 2D, 2E et 2F illustrent le dépôt de la couche diélectrique de façon non conforme sur les flancs des diodes.
La figure 2G illustre le dépôt de la couche diélectrique de façon conforme sur les flancs des diodes.
Les figures 2K et 2M illustrent un mode de réalisation dans lequel le miroir est isolé électriquement de l'électrode commune surmontant les diodes.
Les figures 2L et 2N illustrent un mode de réalisation dans lequel le miroir fait partie de l'électrode commune aux diodes.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un mode de réalisation préféré, la première diode et la deuxième diode présentent chacune un flanc en regard du miroir, et le procédé comprend en outre le dépôt d'une couche diélectrique à base d'un premier matériau diélectrique et recouvrant lesdits flancs de la première diode et la deuxième diode.

La couche diélectrique assure notamment l'isolation électrique entre la première diode et la deuxième diode. Elle s'étend de préférence sur toute la hauteur des flancs de la première diode et de la deuxième diode. Elle s'étend par ailleurs de préférence sur la face supérieure des diodes, ainsi de préférence qu'au fond de la tranchée, typiquement au contact de la face supérieure du substrat. Elle est de préférence continue. De cette façon, l'isolation électrique entre les diodes est optimale.

Selon un exemple, la couche diélectrique est à base d'au moins l'un parmi les matériaux suivants : SiO₂, SiN, SiON, Al₂O₃, AIN. Il peut également s'agir d'un empilement comprenant au moins l'un de ces matériaux.

Selon un exemple préféré, la couche diélectrique présente un premier flanc externe en regard du premier flanc du miroir et un deuxième flanc externe en regard du deuxième flanc du miroir, et le dépôt de la couche diélectrique comprend un dépôt non conforme sur le flanc de la première diode et sur le flanc de la deuxième diode, les paramètres du dépôt non conforme étant réglés de sorte à ce que le premier flanc externe et le deuxième flanc externe de la couche diélectrique s'éloignent respectivement de la première diode et de la deuxième diode dans le plan longitudinal au fur et à mesure qu'ils s'éloignent du substrat. Cela permet de conférer à l'espace restant de la tranchée, en coupe dans le plan XZ, une forme trapézoïdale particulièrement avantageuse pour la formation des flancs inclinés du miroir. Par conséquent, un tel dépôt non conforme de la couche diélectrique permet d'améliorer l'extraction et la captation lumineuse. La non-conformité du dépôt, considérée habituellement comme un inconvénient, est ici utilisée comme un avantage pour réaliser l'inclinaison souhaitée des interfaces de réflexion.

Selon un autre mode de réalisation, la couche diélectrique est déposée de façon conforme sur le flanc de la première diode et sur le flanc de la deuxième diode.

Selon un exemple, lesdits paramètres du dépôt non conforme comprennent notamment : une température de dépôt, une pression de dépôt, une puissance de dépôt et un angle de dépôt mesuré entre un flux d'espèce déposé et le plan longitudinal.

Selon un mode de réalisation avantageux, le procédé comprend en outre, avant la formation du miroir, le dépôt d'un masque perforé sur chacune des diodes, le masque perforé s'étendant partiellement en surplomb de la tranchée. Le masque perforé peut par exemple être à base d'un matériau diélectrique tel que SiO₂, SiN, SiON, Al₂O₃, AIN, ou encore d'un matériau métallique tel que le cuivre, l'aluminium, l'or, l'argent, le nickel, le platine, et le titane ou le nitrure de titane. Le masque perforé est déposé sur la face supérieure des diodes. Le masque perforé peut également être désigné masque d'ombre.

Lorsque la couche diélectrique est déposée sur la face supérieure des diodes, le masque perforé est de préférence déposé au-dessus de la couche diélectrique. Le dépôt du masque perforé intervient donc de préférence après le dépôt de la couche diélectrique.

Le surplomb formé par le masque perforé permet de faciliter la formation du miroir selon la forme avantageuse permettant d'améliorer l'extraction et la captation lumineuse.

Selon un mode de réalisation avantageux, le procédé comprend en outre, après la formation du miroir, la formation d'un revêtement métallique réflecteur sur le premier flanc et le deuxième flanc du miroir, le revêtement métallique étant à base d'un deuxième matériau métallique réflecteur, distinct du premier matériau métallique.

Le deuxième matériau métallique présente de préférence un coefficient de réflexion maximal se situant dans une gamme de longueurs d'ondes distincte de celle dans laquelle se trouve le coefficient de réflexion maximal du premier matériau métallique.

Par exemple, on pourra choisir le premier matériau métallique et le deuxième matériau métallique de sorte que l'un réfléchisse particulièrement bien la lumière rouge, et l'autre la lumière bleue. Le cuivre est par exemple est excellent exemple de premier ou deuxième matériau métallique pour assurer un très bon niveau de réflexion de la lumière rouge.

En superposant de la sorte deux couches métalliques présentant des coefficients de réflexion maximaux dans des gammes distinctes, on peut assurer un très bon niveau de réflexion sur une large plage de longueurs d'ondes. Il n'est alors pas nécessaire de faire un choix entre une bonne réflexion pour une gamme réduite de longueurs d'ondes et une réflexion moyenne assurée pour une gamme de longueurs d'ondes plus large.

Cette variante est particulièrement avantageuse lorsque, sur un même empilement initial, on forme des diodes émettant dans des couleurs distinctes. Il n'est alors pas nécessaire d'adapter la nature du premier matériau métallique à la nature des diodes voisines, ce qui serait complexe à mettre en œuvre et désavantageux en termes de temps et de coût.

L'extraction lumineuse (ou la captation lumineuse) est ainsi améliorée pour l'ensemble de la matrice de diodes, même si celle-ci comprend des diodes de natures différentes.

Il est par ailleurs envisageable de déposer un deuxième revêtement métallique réflecteur à base d'un troisième matériau métallique réflecteur, distinct du premier matériau métallique et du deuxième matériau métallique réflecteur, afin d'élargir encore la gamme de longueurs d'ondes dans la laquelle un très bon niveau de réflexion est atteint. Les trois matériaux métalliques sélectionnés permettront de façon avantageuse de réfléchir pour l'un la lumière rouge, pour un autre la lumière bleue, et pour le dernier la lumière verte.

S'il n'est pas opté pour cette variante intégrant une ou deux couche(s) de revêtement, on pourra par exemple choisir l'aluminium comme premier matériau métallique, qui constitue un bon compromis et permet d'atteindre une réflexion satisfaisante à la fois pour les lumières rouge, verte et bleue.

Selon un mode de réalisation avantageux, le procédé comprend en outre, après la formation du miroir, une étape de remplissage de la tranchée avec un deuxième matériau diélectrique, de préférence identique au premier matériau diélectrique.

Selon un mode de réalisation avantageux, la première diode et la deuxième diode présentent chacune une face supérieure, et le procédé comprend en outre la formation d'une électrode commune en contact avec les faces supérieures des diodes et séparée du miroir par le deuxième matériau diélectrique, l'électrode commune étant à base d'un matériau électriquement conducteur et transparent dans une gamme de longueurs d'ondes dans laquelle la première diode et la deuxième diode émettent ou reçoivent de la lumière.

Dans cet exemple, l'électrode commune et le miroir sont isolés électriquement par le deuxième matériau diélectrique. Par ailleurs, avant d'atteindre le miroir, la lumière émise par les diodes se propage uniquement dans des matériaux diélectriques, voire dans un seul et même matériau diélectrique. Cela permet de limiter les réflexions intempestives entre l'émission de la lumière au niveau des diodes et sa réflexion contre le miroir. Ces réflexions intempestives pourraient en effet se produire selon des angles moins avantageux que celui permis par le miroir. L'extraction lumineuse s'en retrouve donc améliorée. Dans le cas de diodes photoréceptrices, un constat similaire est fait pour la lumière réfléchie contre le miroir et dirigée vers les diodes : la détection lumineuse est améliorée.

Selon un mode de réalisation avantageux, le procédé comprend en outre, après la formation du miroir, une étape de remplissage de la tranchée avec un matériau électriquement conducteur et transparent dans une gamme de longueurs d'ondes dans laquelle la première diode et la deuxième diode émettent ou reçoivent de la lumière.

Selon un mode de réalisation avantageux, la première diode et la deuxième diode présentent chacune une face supérieure et le matériau électriquement conducteur est également déposé au contact des faces supérieures des diodes, de façon à former une couche continue formant avec le miroir une électrode commune aux diodes.

Dans cet exemple, la couche continue de matériau électriquement conducteur et le miroir sont en continuité électrique et forment une électrode commune. Inclure le miroir à l'électrode commune permet ainsi de créer un chemin électrique plus conducteur que celui constitué par le dépôt du matériau électriquement conducteur. On améliore ainsi la rapidité de réponse du dispositif.

Selon un exemple préféré, l'angle de réflexion est inférieur à 85°, de préférence inférieur à 70°.

Selon un exemple, le premier matériau métallique est pris parmi les matériaux suivants : le cuivre, l'aluminium, le titane, le nitrure de titane, l'or, l'argent, le nickel et le platine.

Selon un exemple préféré, la première diode et la deuxième diode présentent chacune un flanc en regard du miroir, le dispositif comprenant en outre une couche diélectrique à base d'un premier matériau diélectrique et recouvrant lesdits flancs de la première diode et la deuxième diode.

Selon un mode de réalisation préféré du dispositif, la couche diélectrique présente un premier flanc externe en regard du premier flanc du miroir et un deuxième flanc externe en regard du deuxième flanc du miroir, le premier flanc externe et le deuxième flanc externe de la couche diélectrique s'éloignant respectivement de la première diode et de la deuxième diode dans le plan longitudinal au fur et à mesure qu'ils s'éloignent du substrat.

Selon un mode de réalisation préféré, le dispositif comprend en outre une couche de remplissage conductrice s'étendant entre la couche diélectrique et le miroir, la couche de remplissage conductrice étant à base d'un matériau électriquement conducteur et transparent dans une gamme de longueurs d'ondes dans laquelle la première diode et la deuxième diode émettent ou reçoivent de la lumière.

Selon un mode de réalisation préféré, la première diode et la deuxième diode présentent chacune une face supérieure et la couche de remplissage conductrice s'étend jusqu'au contact des faces supérieures des diodes, et forme ainsi une couche continue formant avec le miroir une électrode commune aux diodes.

Selon un exemple, la couche diélectrique est à base d'au moins l'un parmi les matériaux suivants : SiO₂, SiN, SiON, AIN, Al₂O₃.

Selon un exemple avantageux, le substrat comprend une pluralité de vias métalliques, chaque via métallique étant sous-jacent, selon une direction transverse perpendiculaire au plan longitudinal, à une diode distincte, et en conduction électrique avec ladite diode.

La présente demande de brevet peut aussi bien s'appliquer à une diode photoréceptrice qu'à une diode photoémettrice (ainsi qu'à des réseaux de telles diodes). Le terme « diode » s'entend donc indifféremment comme « diode photoréceptrice » ou « diode photoémettrice ». Dans la présente demande de brevet, les termes « diode photoémettrice », « diode électroluminescente » et « LED » sont employés en synonymes. Une « diode » peut également s'entendre d'une « micro-diode ». Une « micro-diode » est une diode dont les dimensions n'excèdent pas 1 mm (1 mm = 10⁻³ m).

On entend dans la présente demande qu'une couche est transparente dans une gamme de longueurs d'ondes donnée lorsque celle-ci présente une transmittance supérieure ou égale à 70%, de préférence supérieure à 90%, de préférence supérieure ou égale à 95%. Autrement dit, elle présente une absorbance inférieure ou égale à 30%, de préférence inférieure ou égale à 10%, de préférence inférieure ou égale à 5% dans cette gamme.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant, soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. La sélectivité entre A et B est notée SA:B.

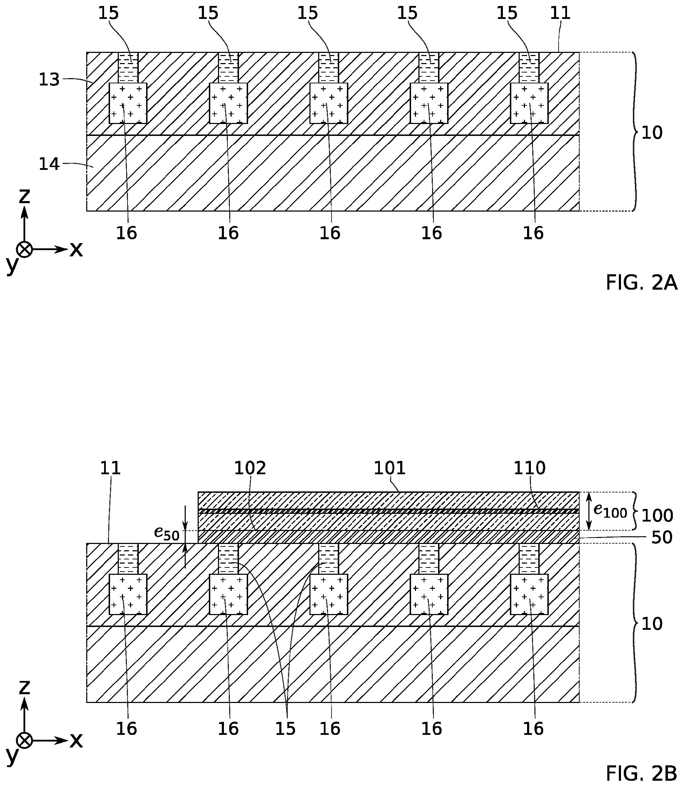

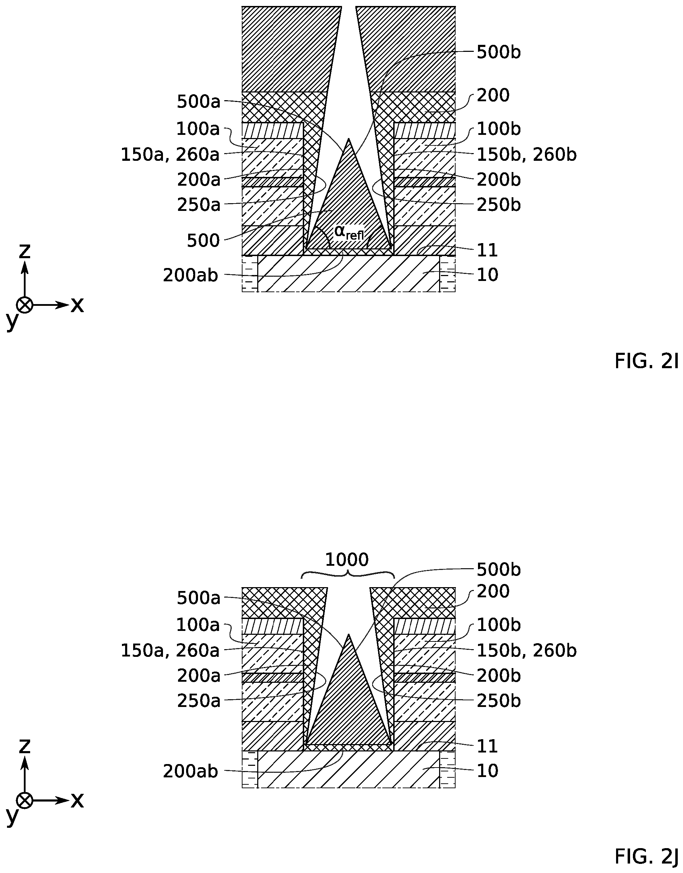

Un repère, de préférence orthonormé, comprenant les axes X, Y, Z est représenté en figures 2A à 2N. La direction Z pourra être désignée « direction d'empilement ».

Dans la présente demande de brevet, on parlera préférentiellement d'épaisseur pour une couche et de hauteur pour une structure ou un dispositif. La hauteur est prise perpendiculairement au plan longitudinal XY. L'épaisseur est prise selon une direction normale au plan d'extension principal de la couche. Ainsi, une couche présente typiquement une épaisseur selon Z, lorsqu'elle s'étend principalement le long du plan longitudinal XY, et un élément en saillie, par exemple une tranchée d'isolation, présente une hauteur selon Z. Les termes relatifs « sur », « sous », « dessus », « dessous », « sous-jacent » se réfèrent préférentiellement à des positions prises selon la direction Z.

Les termes « sensiblement », « environ », « de l'ordre de » signifient « à 10% près, de préférence à 5% près ».

Plusieurs modes de réalisation du procédé selon l'invention vont maintenant être décrits en référence aux figures 2A à 2N.

La figure 2A illustre la fourniture d'un substrat 10. Il s'agit typiquement d'un substrat 10 comprenant un circuit intégré, pouvant être désigné ASIC, de l'anglais « Application Specific Integrated Circuit » (en fran-çais « circuit intégré pour une application spécifique »).

Le substrat 10 présente une face supérieure 11 s'étendant principale-ment dans un plan parallèle au plan longitudinal XY.

Le substrat 10 peut par exemple comprendre une couche affleurante 13 et un substrat support 14. Le substrat support 14 peut par exemple être un substrat de silicium.

Le substrat 10, typiquement la couche affleurante 13, comprend de préférence une pluralité de vias métalliques 15 affleurant de préférence la face supérieure 11 du substrat 10. Chacun de ces vias métalliques 15 peut être en contact avec un plot métallique 16. Les vias métalliques 15 peuvent par exemple être à base de tungstène et les plots métalliques peuvent par exemple être à base de cuivre ou d'aluminium.

La figure 2B illustre ensuite le report, sur la face supérieure 11 du substrat 10, d'un substrat épitaxié 100.

Le substrat épitaxié 100 présente une face inférieure 102 en regard de la face supérieure 11 du substrat 10 et une face supérieure 101, opposée à sa face inférieure 102. Toutes deux s'étendent principalement dans un des plans parallèles au plan longitudinal XY. Le substrat épi-taxié 100 présente selon la direction d'empilement Z une épaisseur e₁₀₀. Typiquement, e₁₀₀ est comprise entre 100 nm et 10 µm.

Le substrat épitaxié 100 est à base d'un matériau semiconducteur. Le substrat épitaxié 100 comprend une région active 110. Cette région active 110 est le lieu de recombinaisons radiatives de paires électron-trou permettant d'émettre (photoémetteur) ou d'absorber (photorécepteur) un rayonnement lumineux. La région active 131 comprend typiquement une pluralité de puits quantiques, par exemple formés par des couches émissives à base de GaN, InN, InGaN, AlGaN, AIN, AlInGaN, GaP, AlGaP, AlInGaP, AlGaAs, GaAs, InGaAs, AllnAs, ou d'une combinaison de plusieurs de ces matériaux.

Afin de garantir la bonne tenue du substrat épitaxié 100 avec le substrat 10, le report du substrat épitaxié 100 peut se faire par collage par l'intermédiaire d'une couche d'adhésion 50 s'étendant entre la face supérieure 11 du substrat 10 et la face inférieure 102 du substrat épitaxié 100. La couche d'adhésion 50 présente une épaisseur e50 selon la direction d'empilement Z.

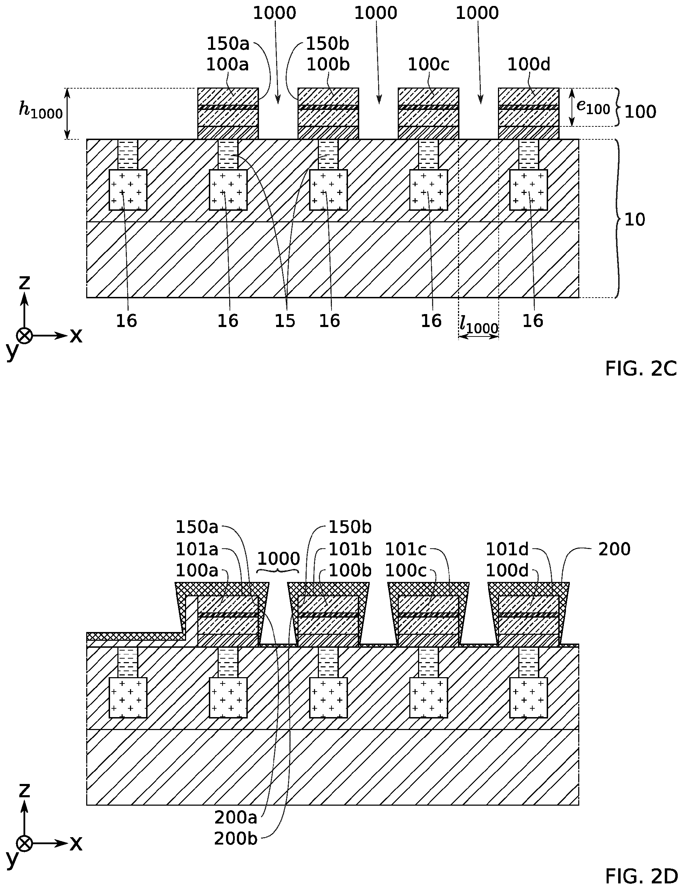

Comme illustré par le passage de la figure 2B à la figure 2C, on procède ensuite à une étape de lithographie et de gravure permettant de singulariser une pluralité d'îlots à partir de la couche active 100. Dans un souci de simplification, la forme évasée donnée aux îlots par cette étape de gravure n'est pas illustrée sur la figure 2C et sur les figures suivantes. Chacun de ces îlots forme une diode 100a, 100b, 100c, 100d. Chaque diode 100a, 100b, 100c, 100d comprend une partie de la région active 110 du substrat épitaxié 100. L'ensemble des diodes 100a, 100b, 100c, 100d est appelé matrice de diodes 100a, 100b, 100c, 100d.

La singularisation des diodes 100a, 100b, 100c, 100d passe par la formation de tranchées 1000 au sein du substrat épitaxié 100. Chacune de ces tranchées 1000 traverse le substrat épitaxié 100 sur toute son épaisseur e100. Si une couche d'adhésion 50 se trouve entre le substrat 10 et le substrat épitaxié 100, les tranchées 1000 traversent de préférence également la couche d'adhésion 50 sur toute son épaisseur e50. Si la couche d'adhésion 50 n'est pas métallique, cette précaution n'est cependant pas nécessaire.

Deux diodes adjacentes (par exemple les diodes référencées 100a et 100b sur les figures) sont séparées par une tranchée 1000. Si l'on considère une première diode 100a et une deuxième diode 100b adjacentes l'une à l'autre, la tranchée 1000 les séparant s'étend au moins entre un flanc 150a de la première diode 100a et un flanc 150b de la deuxième diode 100b. Ces flancs 150a, 150b se trouvent en regard l'un de l'autre. De la même façon, les autres tranchées 1000 s'étendent au moins entre deux flancs de deux diodes adjacentes.

Chaque tranchée 1000 présente une largeur l₁₀₀₀, mesurée entre les deux flancs 150a, 150b des deux diodes 100a, 100b entre lesquels elle s'étend. La largeur l₁₀₀₀ est illustrée en figure 2C. La largeur l₁₀₀₀ correspond à la distance la plus faible entre ces flancs 150a, 150b. La distance entre les flancs 150a, 150b pouvant varier le long de la direction d'empilement Z du fait des effets de gravure, on choisit de mesurer la largeur l₁₀₀₀ au pied des diodes 100a, 100b, c'est-à-dire dans le plan parallèle au plan longitudinal XY incluant les diodes 100a, 100b le plus proche du substrat 10. Dans le cas de flancs 150a, 150b présentant une forme courbe dans le plan longitudinal XY (par exemple si les diodes 100a, 100b présentent une forme circulaire en projection dans le plan longitudinal XY), la largeur l₁₀₀₀ est effective, en projection dans le plan longitudinal XY, entre un unique point du flanc 150a de la première diode 100a et un unique point du flanc 150b de la deuxième diode 100b. Dans le cas de flancs 150a, 150b parallèles entre eux, la largeur l₁₀₀₀ est effective sur toute l'étendue de ces deux flancs 150a, 150b.

Typiquement, l₁₀₀₀ est inférieure à 3 µm, de préférence supérieure à 500 nm, de préférence supérieure à 750 nm, et typiquement sensiblement égale à 1 µm.

Chaque tranchée 1000 présente par ailleurs une hauteur h₁₀₀₀, mesurée en projection dans un plan parallèle à la direction d'empilement Z. h₁₀₀₀ est de préférence supérieure à 100 nm, et typiquement inférieure à 10 µm.

Une couche diélectrique 200 est ensuite avantageusement déposée dans les tranchées 1000 de manière à recouvrir les flancs 150a, 150b des diodes 100a, 100b.

La couche diélectrique 200 est déposée de sorte à présenter au moins une portion latérale 200a recouvrant au moins en partie le flanc 150a de la première diode 100a. Elle est de préférence déposée de sorte à également présenter au moins une autre portion latérale 200b recouvrant au moins en partie le flanc 150b de la deuxième diode 100b.

Les portions latérales 200a, 200b de la couche diélectrique 200 présentent par ailleurs chacune un flanc interne 260a, 260b se trouvant en regard de la première diode 100a et de la deuxième diode 100b respectivement. De préférence, la couche diélectrique 200 est déposée au contact de la première diode 100a et la deuxième diode 100b. Ainsi, les portions latérales 200a, 200b s'étendent de préférence respectivement depuis le flanc 150a de la première diode 100a et depuis le flanc 150b de la deuxième diode 100b. Dans ce cas de figure, les flancs internes 260a, 260b des portions latérales 200a, 200b de la couche diélectrique 200 et les flancs 150a, 150b des première et deuxièmes diodes 100a, 100b sont donc confondus. Les portions latérales 200a, 200b de la couche diélectrique 200 présentent par ailleurs respectivement un premier flanc externe 250a et un deuxième flanc externe 250b, opposés aux flancs internes 260a, 260b.

La couche diélectrique 200 est de préférence également déposée au fond des tranchées 1000, typiquement au contact de la face supérieure 11 du substrat 10 lorsque les tranchées 1000 traversent entièrement la couche d'adhésion 50 ou lorsqu'il n'y a pas de couche d'adhésion 50. La portion de la couche diélectrique 200 formée au fond d'une tranchée 1000 est désignée portion inférieure 200ab. Elle présente une face supérieure 201AB s'étendant principalement dans un plan parallèle au plan longitudinal XY.

La couche diélectrique 200 est par ailleurs avantageusement déposée sur la face supérieure 101 du substrat épitaxié 100, qui, à ce stade du procédé, est composé des faces supérieures 101a, 101b, 101c, 101d de chacune des diodes 100a, 100b, 100c, 100d.

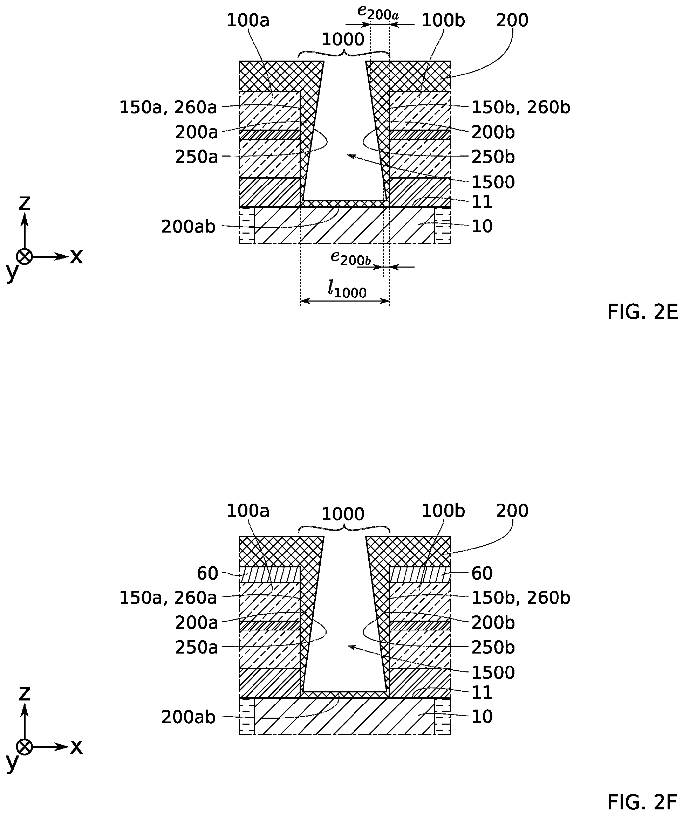

Selon un premier mode de réalisation illustré aux figures 2D, 2E et 2F, le dépôt de cette couche diélectrique 200 se fait de façon non conforme.

La figure 2E est un agrandissement de la figure 2D représentant une tranchée 1000 séparant une première diode 100a d'une deuxième diode 100b. Cette figure permet de mieux visualiser la façon dont est déposée la couche diélectrique 200 au sein d'une tranchée 1000. Les figures suivantes se concentrent également sur ces deux diodes 100a, 100b et la tranchée 1000 les séparant, mais il est entendu que les différentes étapes du procédé peuvent être appliquées à l'ensemble des diodes 100a, 100b, 100c, 100d de la matrice et à l'ensemble des tranchées 1000.

Dans le premier mode de réalisation de la couche diélectrique 200, le dépôt de celle-ci est configuré pour que ses flancs externes 250a, 250b soient inclinés par rapport à la direction d'empilement Z.

Afin de permettre l'inclinaison des flancs externes 250a, 250b, le dépôt de la couche diélectrique 200 comprend avantageusement un dépôt non conforme permettant de former les portions latérales 200a, 200b selon une forme permettant cette inclinaison.

De manière parfaitement classique, un dépôt non conforme se caractérise par le fait que l'épaisseur de la couche déposée n'est pas constante. Cette épaisseur, en tout point de cette couche, est mesurée perpendiculairement à la tangente à la couche ou au motif sous-jacent à la couche conforme. Sur la figure 2E, il ressort clairement que dans ce mode de réalisation l'épaisseur e₂₀₀ₐ de la couche diélectrique 200 au niveau de la face supérieure de la diode 100 est supérieure à l'épaisseur e_{200b} de la couche diélectrique 200 au niveau de la face supérieure de la diode 100. e₂₀₀ₐ est typiquement supérieure à 10 nm, par exemple supérieure à 30 nm. e₂₀₀ₐ est typiquement inférieure à 1 µm, par exemple inférieure à 300 nm.

De préférence, le dépôt non conforme est effectué de sorte à ce que les flancs externes 250a, 250b présentent une pente constante. Ainsi l'épaisseur e₂₀₀ de la couche diélectrique augmente de manière continue en direction de l'ouverture de la tranchée 1000.

Un tel dépôt peut être réalisé par dépôt chimique en phase vapeur assisté par plasma (couramment désigné PECVD, de l'anglais « Plasma Enhanced Chemical Vapor Deposition »), par dépôt physique en phase vapeur (couramment désigné PVD, de l'anglais « Physical Vapor Deposition »), ou encore par dépôt par faisceau ionique (couramment désigné IBD, de l'anglais « Ion Beam Deposition »). Quel que soit le procédé retenu, les paramètres de celui-ci sont ajustés afin d'obtenir un dépôt non conforme. En particulier, les paramètres suivants sont ajustés pour obtenir le dépôt non conforme que l'on souhaite : la puissance de dépôt, la pression, la température de dépôt, l'angle de dépôt.

Plusieurs procédés pouvant être utilisés pour former la couche diélectrique 200 de façon non conforme sont décrits ci-dessous :
- Dépôt CVD dans un générateur haute fréquence (ex : 13,56 MHz), à une puissance de 300W, à une pression de 2,5 Torr et une température de 240°C, par exemple avec pour gaz oxydant du N₂O et de préférence avec du silane (SiH4) comme gaz précurseur. Le ratio du gaz oxydant sur le gaz précurseur est supérieur ou égal à 20, de préférence supérieur ou égal à 80.
- Dépôt PVD avec une cible en SiO₂, un mélange d'argon (30sccm) et de O2 (45 sccm), avec un générateur en mode DC pulsé et une puissance de 3000W, une pression de 0.5 mT et à température ambiante. Le dépôt se fait de préférence selon la direction d'empilement Z.
- Dépôt IBD avec une cible en SiO₂, des ions krypton (4 sccm), un plasma généré avec un générateur radiofréquence (RF), une puissance de 700 W, une pression de 0,45 mT, un angle de dépôt - c'est-à-dire l'angle entre le flux d'espèces à déposer et le plan longitudinal XY - de 5°, et à température ambiante.

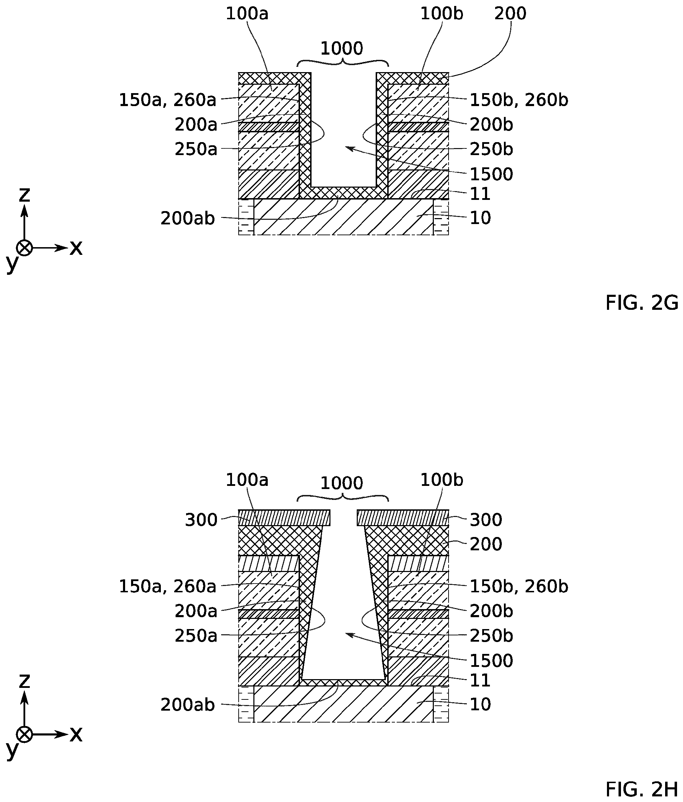

Selon un deuxième mode de réalisation illustré à la figure 2G, la couche diélectrique 200 est déposée de façon conforme.

Comme cela est illustré à la figure 2F, il est possible de conserver un masque de lithographie 60, tel qu'un masque de résine photosensible, ayant servi à singulariser les diodes par formation des tranchées 100 (étapes de masquage et de photolithographie non illustrées se déroulant entre les figures 2B et 2C). La couche diélectrique 200 est alors déposée sur ce masque 60. Il est cependant également possible de retirer ce masque et déposer la couche diélectrique 200 directement au contact de la face supérieure 101a, 101b des diodes 100a, 100b, comme illustré en figures 2E et 2G par exemple.

La couche diélectrique 200 est à base d'un matériau diélectrique. Le matériau diélectrique et l'épaisseur de la couche diélectrique 200 sont choisis de sorte que la couche diélectrique 200 soit transparente dans la gamme d'émission ou de réception des diodes 100a, 100b, 100c, 100d. On parle de gamme d'émission pour des diodes photoémettrices et de gamme de réception pour des diodes photoréceptrices. Pour désigner de façon générale l'une ou l'autre de ces gammes, en fonction de la nature de la diode, on parle de gamme d'intérêt.

Lorsque la couche diélectrique 200 n'est pas déposée de façon conforme et ne présente donc pas une épaisseur constante, on évaluera le caractère transparent de la couche diélectrique 200 dans ses portions les plus épaisses. Typiquement, la couche diélectrique 200 est la plus épaisse dans ses portions surmontant les diodes 100a, 100b, 100c, 100d et/ou au niveau le plus éloigné du substrat 10 de ses portions latérales 200a, 200b.

La couche diélectrique 200 peut notamment être à base de l'un parmi le SiO₂, le SiN, le SiON ou encore l'alumine. Il peut également s'agir d'un empilement de plusieurs de ces matériaux.

Suite au dépôt de la couche diélectrique 200, on prévoit de manière avantageuse le dépôt d'un masque perforé 300 sur la face supérieure 101a, 101b des diodes 100a, 100b. Comme illustré à la figure 2H, en projection dans le plan longitudinal XY, ce masque perforé 300 s'étend au-delà des faces supérieures 101a, 101b des diodes 100a, 100b. Il s'étend ainsi en surplomb de la tranchée 100. Il s'étend par ailleurs de préférence, en projection dans le plan longitudinal XY, au-delà des portions latérales 200a, 200b de la couche diélectrique 200. Le masque perforé 300 forme ainsi une avancé au-dessus de la tranchée 1000. Il définit au-dessus de cette tranchée 1000 une ouverture étroite particulièrement avantageuse pour la formation du miroir 500 qui sera décrit plus avant.

L'empilement fourni au début du procédé selon l'invention peut correspondre aux empilements illustrés aux figures 2D, 2E, 2F, 2G ou encore 2H.

Suite à cette étape de fourniture, un miroir 500 à base d'un premier matériau métallique est formé dans la tranchée 1000. Le miroir 500 a pour fonction de réfléchir la lumière émise par les diodes 100a, 100b ou réfléchir de la lumière arrivant vers le dispositif 1 en direction des diodes 100a, 100b. Le premier matériau métallique peut notamment être choisi parmi les matériaux suivants : le cuivre, l'aluminium, , , l'or, l'argent, le nickel, le platine, et le titane.

Ce miroir 500 est déposé par un procédé de dépôt en phase vapeur du premier matériau métallique. Une fois déposé, le miroir 500 présente des flancs 500a, 500b formant des interfaces de réflexion. Le dépôt est configuré de sorte que les flancs 500a, 500b du miroir 500 sont inclinés par rapport à la direction d'empilement Z. Le premier flanc 500a du miroir 500, se trouvant en regard de la première diode 100a, et le deuxième flanc 500b du miroir 500, se trouvant en regard de la deuxième diode 100b, forment chacun un angle de réflexion α_{refl}, mesuré dans le miroir 500. Cet angle de réflexion α_{refl} est de préférence inférieur à 89°. Avantageusement, il est même inférieur à 85° voire à 70°, ce qui permet une meilleure extraction lumineuse (ou détection, dans le cas de diodes photoréceptrices).

Les paramètres suivants peuvent être adaptés pour obtenir une telle inclinaison des flancs 500a, 500b du miroir 500 :
- Les dimensions de la tranchées 1000, et notamment h₁₀₀₀ et l₁₀₀₀.
- Au moins un paramètre de dépôt du premier matériau métallique, tel que :
   i. La distance entre la source de premier matériau métallique (cible) et l'empilement fourni en début de procédé. Typiquement, cette distance est supérieure à 10 cm, de préférence supérieure à 50 cm. Cela permet d'éliminer les espèces qui ont une directionnalité éloignée de l'incidence normale. Cela est applicable par exemple dans un procédé de pulvérisation ou d'évaporation.
   ii. Le dépôt d'ions plutôt que des espèces neutres, afin d'augmenter la directionnalité en incidence normale des espèces grâce à une polarisation du substrat, applicable par exemple dans un procédé de pulvérisation.
   iii. L'utilisation d'un collimateur entre la cible et l'empilement afin de filtrer les espèces dont l'angle d'incidence serait trop éloigné de l'incidence normale, applicable par exemple dans un procédé de pulvérisation ou d'évaporation.
   iv. La pression de dépôt. Typiquement, cette pression est inférieure à 0,1 Pascal (Pa), idéalement inférieure à 1,0×10⁻⁴ Pa afin de minimiser la diffusion des espèces durant le trajet de la cible vers l'empilement, applicable par exemple dans un procédé de pulvérisation, d'évaporation ou d'épitaxie par jet moléculaire.
- Les dimensions des portions latérales 200a, 200b de la couche diélectrique 200, notamment son épaisseur e₂₀₀ₐ (typiquement 0,1 à 1µm) et e_{200b} (typiquement 0,01 à 0,1µm) au niveau des faces supérieures des diodes 100a, 100b
- Les dimensions du masque perforé 300, si un tel masque est déposé.

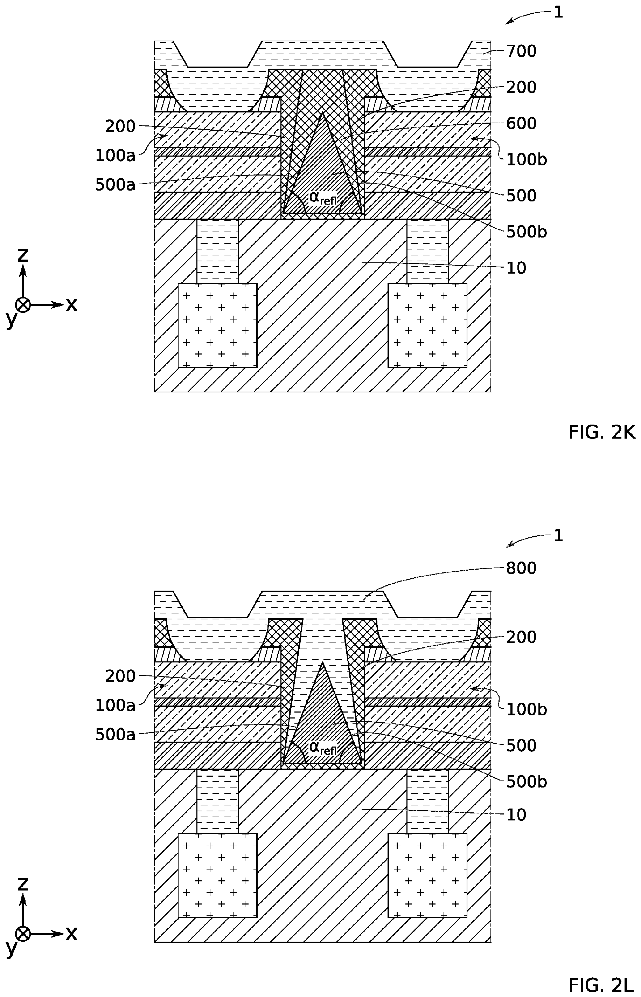

Le résultat de cette étape de dépôt est illustré en figure 2l. Comme illustré, lors de ce dépôt, le premier matériau métallique est également déposé au-dessus des diodes 100a, 100b, typiquement sur la couche diélectrique 200. Ces portions se trouvant sur les faces supérieures 101a, 101b des diodes électroluminescentes 100a, 100b sont ensuite de préférence retirées lors d'une étape de polissage (Fig. 2J), par exemple par polissage mécano-chimique (couramment désigné CMP, de l'anglais « Chemical-Mechanical Polishing »). Cela permet d'éviter que la lumière émise par les diodes 100A, 100B ne soit réfléchie en direction du substrat 10.

Suite au dépôt du miroir 500, il est possible de déposer sur celui-ci un revêtement métallique à base d'un deuxième matériau métallique réflecteur, distinct du premier matériau métallique. Le revêtement métallique réflecteur peut par exemple être déposé de façon conforme sur les flancs 500a, 500b du miroir 500. Le deuxième matériau métallique présente de préférence un coefficient de réflexion maximal se situant dans une gamme de longueurs d'ondes distincte de celle dans laquelle se trouve le coefficient de réflexion maximal du premier matériau métallique. La présence des deux matériaux métalliques distincts permet ainsi d'assurer la réflexion de lumière dans une plus large gamme de longueurs d'ondes que si un seul matériau métallique était présent.

La formation du miroir 500 est de préférence suivie d'une étape de remplissage de la tranchée 1000. On distingue deux principaux modes de réalisation détaillés ci-dessous.

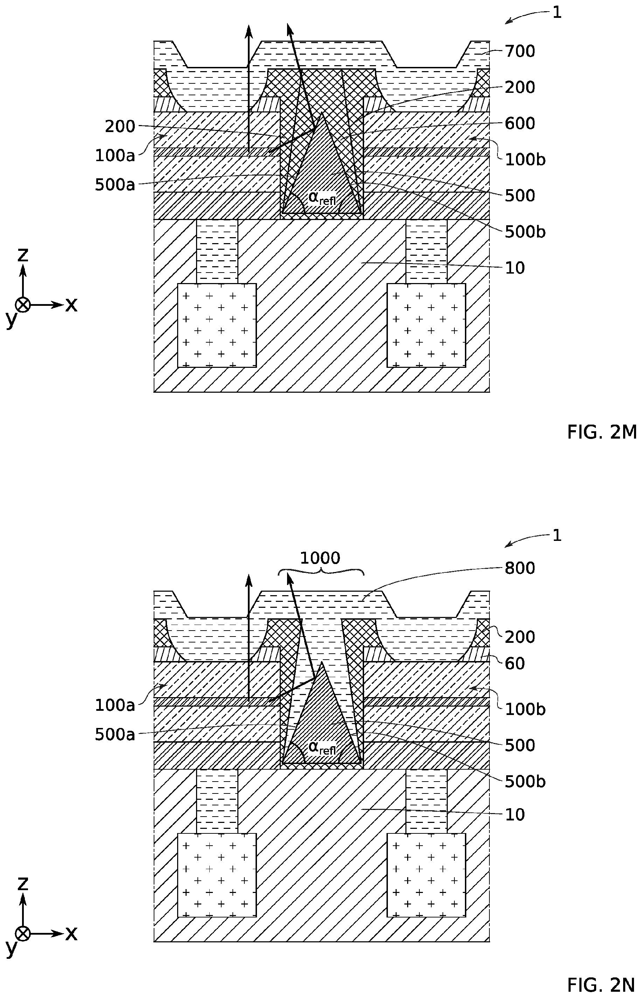

Selon un premier mode de réalisation illustré en figure 2K et 2M, la tranchée 1000 est remplie par une couche de remplissage isolante 600 à base d'un deuxième matériau diélectrique, qui peut être identique au premier matériau diélectrique de la couche 200.

Ensuite, si la couche diélectrique 200, et éventuellement un masque 60, ont été déposés/conservés sur ces faces supérieures 101a, 101b, on forme des ouvertures dedans de sorte à exposer au moins partiellement les faces supérieures 101a, 101b des diodes 100a, 100b. On dépose ensuite avantageusement une électrode commune 700 au contact des faces supérieures 101a, 101b des diodes 100a, 100b. Cette électrode commune 700 est continue et s'étend notamment au-dessus de la tranchée 1000 et notamment du miroir 500. L'électrode commune 700 est à base d'un matériau électriquement conducteur. Ce dernier est de préférence transparent dans une gamme de longueurs d'ondes dans laquelle la première diode et la deuxième diode émettent ou reçoivent de la lumière.

Dans ce premier mode de réalisation, l'électrode commune 700 et le miroir 500 sont isolés électriquement par le deuxième matériau diélectrique. Selon une variante de ce mode de réalisation, l'électrode commune 700 et le miroir 500 sont reliés électriquement, par exemple par un via dans la couche de remplissage isolante 600.

Par ailleurs, dans ce premier mode de réalisation, il n'est pas nécessaire de déposer la couche diélectrique 200 sur les flancs 150a, 150b des diodes 100a, 100b car l'isolation électrique entre le miroir 500 et les diodes 100a, 100b est de toute façon assurée par la couche de remplissage isolante 600.

La figure 2M illustre schématiquement la réflexion de la lumière émise par la première diode 100a par l'interface de réflexion formée par le premier flanc 500a du miroir dans ce premier mode de réalisation. L'inclinaison selon l'angle α_{refl} de cette interface permet de rediriger la lumière afin de permettre son extraction par la face supérieure 101a de la diode 100a.

Selon un deuxième mode de réalisation illustré en figure 2L et 2N, le volume entre la couche diélectrique 200 et le miroir 500 est rempli par une couche de remplissage conductrice 800 à base d'un matériau électriquement conducteur. La couche de remplissage conductrice 800 et le miroir 500 sont alors en contact. Le matériau électriquement conducteur de préférence transparent dans une gamme de longueurs d'ondes dans laquelle la première diode et la deuxième diode émettent ou reçoivent de la lumière. La lumière le traversera alors pour être réfléchie au niveau des flancs 500a, 500b.

Selon un exemple particulièrement avantageux, la couche de remplissage conductrice 800 est également déposée au-dessus des diodes 100a, 100b, au contact de leurs faces supérieures 101a, 101b respectives. Si la couche diélectrique 200, et éventuellement un masque 60, ont été déposés/conservés sur ces faces supérieures 101a, 101b, on forme préalablement des ouvertures dedans de sorte à exposer au moins partiellement les faces supérieures 101a, 101b des diodes 100a, 100b. On dépose ensuite la couche de remplissage conductrice 800 dans la tranchée 1000 et au contact des faces supérieures 101a, 101b des diodes 100a, 100b, et ce de manière continue. La couche de remplissage conductrice 800 et le miroir 500 forment alors ensemble une électrode commune aux diodes 100a, 100b. Les matériaux pouvant être utilisés comme premier matériau métallique pour le miroir 500 étant de particulièrement bons conducteurs électriques, ce mode de réalisation permet de diminuer la résistance électrique d'accès du dispositif optoélectronique.

Dans ce deuxième mode de réalisation, on prendra soin de déposer la couche diélectrique 200 sur les flancs 150a, 150b des diodes 100a, 100b pour assurer l'isolation électrique entre le miroir 500 et la couche de remplissage conductrice 800 d'une part et les diodes 100a, 100b d'autre part.

La figure 2N illustre schématiquement la réflexion de la lumière émise par la première diode 100a par l'interface de réflexion formée par le premier flanc 500a du miroir dans ce deuxième mode de réalisation. L'inclinaison selon l'angle α_{refl} de cette interface permet de rediriger la lumière afin de permettre son extraction par la face supérieure 101a de la diode 100a.

Dans les deux modes de réalisation décrits ci-dessus, il est ensuite avantageux de déposer une couche anti-réfléchissante à base d'un matériau diélectrique au-dessus de l'électrode commune 700 ou de la couche de remplissage conductrice 800. La couche anti-réflechissante peut par exemple être à base de SiO2, SiN, SiON, ou encore être une multi-couche de plusieurs de ces éléments. Cette couche anti-réfléchissante (non représentée sur les figures) permet d'augmenter l'extraction lumineuse. Elle permet également de protéger le matériau électriquement conducteur formant l'électrode commune 700 ou de la couche de remplissage conductrice 800.

Un autre aspect de l'invention concerne un dispositif électronique pouvant être obtenu par l'un quelconque des modes de réalisation du procédé selon l'invention décrits précédemment.

Ce dispositif comprend au moins le substrat 10, la première diode 100a et la deuxième diode 100b au sein de la matrice de diodes 100a, 100b, 100c, 100d, ainsi que le miroir 500 tel que défini précédemment en référence au procédé selon l'invention.

Les figures 2K et 2L illustrent deux modes de réalisation différents de ce dispositif.

A travers les différents modes de réalisation décrits ci-dessus, il apparaît clairement que l'invention propose une solution efficace pour améliorer l'extraction lumineuse et réduire la diaphonie optique dans une matrice de micro-LED.

L'invention n'est pas limitée aux modes de réalisations précédemment décrits et s'étend à tous les modes de réalisation couverts par l'invention.

## Revendications

1. Procédé de fabrication d'un dispositif optoélectronique (1) comprenant les étapes suivantes :
• fournir un empilement comprenant :
i. un substrat (10) présentant une face supérieure (11) s'étendant principalement dans un plan dit plan longitudinal (XY),
ii. une matrice de diodes (100a, 100b, 100c, 100d) photoémettrices ou photoréceptrices disposées sur la face supérieure (11) du substrat (10), au moins une première diode (100a) et une deuxième diode (100b) de la matrice étant séparées par une tranchée (1000),
• former dans la tranchée (1000) un miroir (500) à base d'un premier matériau métallique, la formation du miroir (500) comprenant une étape de dépôt du premier matériau métallique en phase vapeur,
**caractérisé en ce que** les dimensions de la tranchée (1000) et au moins un paramètre de dépôt du premier matériau métallique en phase vapeur sont configurés pour que le miroir (500) présente :
• un premier flanc (500a) orienté en regard de la première diode (100a), formant une interface dite première interface de réflexion pour de la lumière émise ou reçue par la première diode (100a),
• un deuxième flanc (500b) orienté en regard de la deuxième diode (100a) formant une interface dite deuxième interface de réflexion pour de la lumière émise ou reçue par la deuxième diode (100b),
de sorte que la première interface de réflexion et la deuxième interface de réflexion forment chacune un angle dit de réflexion avec le plan longitudinal (XY), mesuré dans le miroir (500), inférieur à 89°, de sorte que la première interface de réflexion et la deuxième interface de réflexion s'éloignent respectivement de la première diode (100a) et de la deuxième diode (100b) dans le plan longitudinal (XY) au fur et à mesure qu'elles s'éloignent du substrat (10).

2. Procédé selon la revendication précédente dans lequel la première diode (100a) et la deuxième diode (100b) présentent chacune un flanc (150a, 150b) en regard du miroir (500), le procédé comprenant en outre le dépôt d'une couche diélectrique (200) à base d'un premier matériau diélectrique et recouvrant lesdits flancs (150a, 150b) de la première diode (100a) et la deuxième diode (100b).

3. Procédé selon la revendication précédente dans lequel la couche diélectrique (200) présente un premier flanc externe (250a) en regard du premier flanc (500a) du miroir (500) et un deuxième flanc externe (250b) en regard du deuxième flanc (500b) du miroir (500), et dans lequel le dépôt de la couche diélectrique (200) comprend un dépôt non conforme sur le flanc (150a) de la première diode (100a) et sur le flanc (150b) de la deuxième diode (100b), les paramètres du dépôt non conforme étant réglés de sorte à ce que le premier flanc externe (250a) et le deuxième flanc externe (250b) de la couche diélectrique (200) s'éloignent respectivement de la première diode (100a) et de la deuxième diode (100b) dans le plan longitudinal (XY) au fur et à mesure qu'ils s'éloignent du substrat (10).

4. Procédé selon la revendication précédente dans lequel lesdits paramètres du dépôt non conforme comprennent notamment : une température de dépôt, une pression de dépôt, une puissance de dépôt et un angle de dépôt mesuré entre un flux d'espèce déposé et le plan longitudinal (XY).

5. Procédé selon l'une quelconque des revendications précédentes comprenant en outre, avant la formation du miroir (500), le dépôt d'un masque perforé (300) sur chacune des diodes (100a, 100b), le masque (300) s'étendant partiellement en surplomb de la tranchée (1000).

6. Procédé selon l'une quelconque des revendications précédentes comprenant en outre, après la formation du miroir (500), la formation d'un revêtement métallique réflecteur sur le premier flanc (500a) et le deuxième flanc (500b) du miroir (500), le revêtement métallique étant à base d'un deuxième matériau métallique réflecteur, distinct du premier matériau métallique.

7. Procédé selon l'une quelconque des revendications précédentes comprenant en outre, après la formation du miroir (500), une étape de remplissage de la tranchée (1000) avec un deuxième matériau diélectrique.

8. Procédé selon la revendication précédente dans lequel la première diode (100a) et la deuxième diode (100b) présentent chacune une face supérieure (101a, 101b), comprenant en outre la formation d'une électrode commune (700) en contact avec les faces supérieures (101a, 101b) des diodes (100a, 100b) et séparée du miroir (500) par le deuxième matériau diélectrique, l'électrode commune (700) étant à base d'un matériau électriquement conducteur et transparent dans une gamme de longueurs d'ondes dans laquelle la première diode (100a) et la deuxième diode (100b) émettent ou reçoivent de la lumière.

9. Procédé selon la revendication 2 en combinaison avec l'une quelconque des revendications 1 à 6, comprenant en outre, après la formation du miroir (500), une étape de remplissage de la tranchée (1000) avec un matériau électriquement conducteur et transparent dans une gamme de longueurs d'ondes dans laquelle la première diode (100a) et la deuxième diode (100b) émettent ou reçoivent de la lumière.

10. Procédé selon la revendication précédente dans lequel la première diode (100a) et la deuxième diode (100b) présentent chacune une face supérieure (101a, 101b) et dans lequel le matériau électriquement conducteur est également déposé au contact des faces supérieures (101a, 101b) des diodes (100a, 100b), de façon à former une couche continue formant avec le miroir (500) une électrode commune aux diodes (100a, 100b).

11. Dispositif optoélectronique (1) comprenant :
• un substrat (10) présentant une face supérieure (11) s'étendant principalement dans un plan dit plan longitudinal (XY),
• une matrice de diodes (100a, 100b, 100c, 100d) photoémettrices ou photoréceptrices disposées sur la face supérieure (11) du substrat (10), au moins une première diode (100a) et une deuxième diode (100b) de la matrice étant séparées par une tranchée (1000),
**caractérisé en ce que** la tranchée (1000) comprend un miroir (500) à base d'un premier matériau métallique, le miroir (500) présentant :
• un premier flanc (500a) en regard de la première diode (100a), formant une interface dite première interface de réflexion pour de la lumière émise ou reçue par la première diode (100a),
• un deuxième flanc (500b) en regard de la deuxième diode (100a) formant une interface dite deuxième interface de réflexion pour de la lumière émise ou reçue par la deuxième diode (100b),
de sorte que la première interface de réflexion et la deuxième interface de réflexion forment chacune un angle dit de réflexion avec le plan longitudinal (XY), mesuré dans le miroir (500), inférieur à 89°, de sorte que la première interface de réflexion et la deuxième interface de réflexion s'éloignent respectivement de la première diode (100a) et de la deuxième diode (100b) dans le plan longitudinal (XY) au fur et à mesure qu'elles s'éloignent du substrat (10), le miroir (500) s'étendant dans tout le volume défini entre son premier flanc (500a) et son deuxième flanc (500b).

12. Dispositif selon la revendication précédente dans lequel la première diode (100a) et la deuxième diode (100b) présentent chacune un flanc (150a, 150b) en regard du miroir (500), le dispositif comprenant en outre une couche diélectrique (200) à base d'un premier matériau diélectrique et recouvrant lesdits flancs (150a, 150b) de la première diode (100a) et la deuxième diode (100b).

13. Dispositif selon la revendication précédente dans lequel la couche diélectrique (200) présente un premier flanc externe (250a) en regard du premier flanc (500a) du miroir (500) et un deuxième flanc externe (250b) en regard du deuxième flanc (500b) du miroir (500), le premier flanc externe (250a) et le deuxième flanc externe (250b) de la couche diélectrique (200) s'éloignant respectivement de la première diode (100a) et de la deuxième diode (100b) dans le plan longitudinal (XY) au fur et à mesure qu'ils s'éloignent du substrat (10).

14. Dispositif selon l'une quelconque des deux revendications précédentes comprenant en outre une couche de remplissage conductrice (800) s'étendant entre la couche diélectrique (200) et le miroir (500), la couche de remplissage conductrice (800) étant à base d'un matériau électriquement conducteur et transparent dans une gamme de longueurs d'ondes dans laquelle la première diode (100a) et la deuxième diode (100b) émettent ou reçoivent de la lumière.

15. Dispositif selon la revendication précédente dans lequel la première diode (100a) et la deuxième diode (100b) présentent chacune une face supérieure (101a, 101b) et dans lequel la couche de remplissage conductrice (800) s'étend jusqu'au contact des faces supérieures (101a, 101b) des diodes (100a, 100b), et forme ainsi une couche continue formant avec le miroir (500) une électrode commune aux diodes (100a, 100b).
